# EUROPÄISCHE PATENTSCHRIFT

(11) **EP 2 308 090 B1**
(45) Veröffentlichungstag und Bekanntmachung des Hinweises auf die Patenterteilung: **07.03.2012**
(21) Anmeldenummer: 09775952.6
(22) Anmeldetag: 11.07.2009
(51) Int. Cl.: H01L 27/142, H01L 31/0224, H01L 31/18

(54) **EINSEITIG KONTAKTIERTES DÜNNSCHICHT-SOLARMODUL MIT EINER INNEREN KONTAKTSCHICHT.**
THIN-FILM SOLAR MODULE WHICH IS CONTACT-CONNECTED ON ONE SIDE AND HAS AN INTERNAL CONTACT LAYER
MODULE SOLAIRE EN COUCHES MINCES À CONTACTS D'UN SEUL CÔTÉ ET COMPRENANT UNE COUCHE DE CONTACT INTÉRIEURE

(30) Priorität: 30.07.2008 DE 102008035327; 01.12.2008 DE 102008060404
(43) Veröffentlichungstag der Anmeldung: 13.04.2011
(73) Patentinhaber: Helmholtz-Zentrum Berlin für Materialien und Energie GmbH, 14109 Berlin (DE)
(72) Erfinder: STANGL, Rolf, 12435 Berlin (DE); LIPS, Klaus, 10781 Berlin (DE); RECH, Bernd, 12587 Berlin (DE)
(86) Internationale Anmeldenummer: PCT/DE2009/000966
(87) Internationale Veröffentlichungsnummer: WO 2010/012259

(56) Entgegenhaltungen:
- WO-A1-97/21253
- WO-A1-03/019674
- DE-A1- 19 854 269
- DE-T5-112005 002 592

## Beschreibung

Die Erfindung bezieht sich auf ein einseitig kontaktiertes Dünnschicht-Solarmodul mit einer Trägerschicht, einer photoaktiven Absorberschicht und zumindest einer auf einer Seite der Absorberschicht ganzflächig abgeschiedenen Dotierschicht sowie weiteren Funktionsschichten, wobei das daraus gebildete Dünnschichtpaket durch isolierende Trenngräben in Solarzellenbereiche unterteilt ist, und mit einem Kontaktierungen und eine diese verbindende Kontaktschicht aufweisenden ersten Kontaktsystem und einem eine Kontaktschicht aufweisenden zweiten Kontaktsystem auf der trägerschichtabgewandten Seite der Absorberschicht zur getrennten Ableitung von durch Lichteinfall in der Absorberschicht erzeugten überschüssigen Ladungsträgern (p, n), wobei beide Kontaktsysteme innerhalb von Verschaltungsbereichen in Serie geschaltet und außerhalb der Verschaltungsbereiche elektrisch gegeneinander isoliert sind, und auf ein Verfahren zur Herstellung eines derartigen Dünnschicht-Solarmoduls.

In Dünnschichttechnologie gefertigte Solarmodule basieren auf Halbleitern, die vorzugsweise großflächig auf zumeist preiswerte Trägerschichten, wie Glas, Metall- oder Plastikfolien, aufgebracht werden. Die verschiedenen Technologievarianten sind zwar noch nicht in gleicher Weise zur Serienreife gebracht worden wie die Silizium-Wafer-Technologie, bieten aber mittelfristig das größere Kostenreduktionspotenzial. Teures Halbleitermaterial wird im Vergleich zur konventionellen Wafer-Technologie eingespart. Im Fall von kristallinem Silizium ist dies besonders wichtig, weil die Kapazitäten zur Herstellung des Siliziums zur Deckung der Nachfrage derzeit nicht ausreichen. Außerdem entfällt bei Dünnschicht-Solarmodulen das Zusammensetzen aus einzelnen Solarzellen. Die großflächig abgeschiedenen Dünnschichtpakete werden in kleinere Bereiche (zumeist parallele streifenförmige Solarzellenbereiche) unterteilt und dann integriert serienverschaltet. Es lassen sich so bis zu Quadratmeter große Trägerschichten beschichten, was den Handhabungsaufwand in der Fabrik signifikant reduziert. Die Herausforderung bei Dünnschicht-Solarmodulen liegt in der Erreichung effizienter Wirkungsgrade durch eine ausreichende Lichtabsorption in den Funktionsschichten.

Die Solarzellenbereiche der Dünnschicht-Solarmodule wandeln Licht in elektrische Energie um. Üblicherweise bestehen sie aus direkten oder indirekten Halbleitermaterialien, die durch Dotierung Schichten oder Bereiche unterschiedlicher Leitfähigkeit für positive (p, Löcher, p-typ) und negative (n, Elektronen, n-typ) Ladungsträger enthalten. Diese Schichten sollen im Folgenden als "Dotierschichten" zur Sammlung der Ladungsträger bezeichnet werden. Durch einfallendes Licht erzeugte positive und negative überschüssige Ladungsträger werden hauptsächlich in der Absorberschicht generiert, diese ist bei einer pin-Konfiguration nicht (intrinsisch, i) oder nur schwach dotiert und steht beiderseits sowohl mit stark n-typ als auch mit stark p-typ leitenden Dotierschichten im Kontakt. Ist die Absorberschicht dotiert, so wird die zumindest eine stark gegendotierte Schicht als Emitterschicht bezeichnet und es liegt eine pn-Konfiguration vor. Optional können Absorber- und Emitterschicht noch mit stark gleichdotierten Funktionsschichten im Kontakt sein. Es entstehen Feldpassivierungsschichten, der an der Front- oder Rückseite der Rückstreuung ungesammelter Ladungsträger dienen (BSF- bzw. FSF-Schichten oder -Bereiche). Die überschüssigen Ladungsträger werden entweder am pn-Übergang zwischen Emitter- und Absorberschicht (pn-Konfiguration unter Verwendung einer dotierten Absorberschicht) oder durch das elektrische Feld in der intrinsischen oder schwach dotierten Absorberschicht, das durch die auf beiden Seiten der Absorberschicht angeordneten n-typ- und p-typ- Dotierschichten aufgespannt wird (pin-Konfiguration unter Verwendung einer intrinsischen Absorberschicht), getrennt und können durch mit den jeweiligen Bereichen/Schichten elektrisch leitend verbundenen Kontaktsystemen gesammelt und abgeführt werden. Die pin-Konfiguration kann als Grenzfall der pn-Konfiguration mit einem speziellen Dotierungsprofil angesehen sein. Zur nutzbaren elektrischen Leistung von Dünnschicht-Solarmodulen tragen jedoch nur solche überschüssigen Ladungsträger bei, die die Kontaktsysteme auch erreichen und nicht vorher rekombinieren.

Dünnschicht-Solarzellen mit einer ultradünnen Absorberschicht sind im Gegensatz zu konventionellen mono- oder multikristallinen Solarzellen aus Silizium-Wafern etwa um den Faktor 100 dünner. Für die jeweiligen Solarzellenmaterialien sind unterschiedliche industrielle Herstellungsverfahren vom Bedampfen des Trägermaterials im Hochvakuum bis zu Sprühverfahren verfügbar. Durch Dünnschicht-Solarzellen wird langfristig eine wesentliche Preissenkung von Photovoltaikanlagen erwartet. Materialeinsparung, Erforschung neuer Halbleitermaterialien, Niedertemperaturprozesse, die deutlich energieeffizienter sind, einfache Modulherstellung durch Strukturierung flächiger Solarzellenbereiche und ein hoher Automatisierungsgrad ermöglichen niedrigere Herstellungskosten. Neben den Dünnschicht-Solarzellen aus amorphem Silizium (a-Si:H) oder Chalkogenid-Verbindungshalbleitern (Cl(G)S(e), CdTe) sind insbesondere Dünnschicht-Solarzellen aus mikro- oder polykristallinem Silizium (µc-Si, polyc-Si; c-Si steht für beide Sorten) auf längere Sicht sehr attraktiv, weil sie das Potenzial zu hohen Wirkungsgraden besitzen, ökologisch unbedenklich sind und das Ausgangsmaterial ausreichend vorhanden ist. Besonders viel versprechend ist auch die Kombination aus mikro- oder polykristallinem Silizium als Absorber und amorphem Silizium als Emitter, da dessen Bandlücke aufgrund des enthaltenen Wasserstoffs größer ist als die des kristallinem Siliziums (c-Si/a-Si:H) und a-Si:H die Absorbergrenzfläche gut passivieren kann.

In der Regel weisen kommerziell erhältliche Dünnschicht-Solarmodule eine zweiseitige Serienverschaltung auf, bei der ein flächiger Kontakt der Solarzellen-Rückseite mit einem flächigen Kontakt der Solarzellen-Vorderseite verbunden wird. Dies bedingt eine beidseitige Kontaktierung der vereinzelten Solarzellenbereiche. Hieraus resultiert jedoch ein verhältnismäßig großer, effizienzmindernder Totbereich im fertigen Solarmodul. Aufgrund der beidseitig-flächigen Kontaktierung sind den Wirkungsgrad steigernde Konzepte, wie z.B. die Einführung von punktförmigen Kontaktierungen oder einer ausschließlichen Rückseitenkontaktierung unter Vermeidung von Absorptionsverlusten durch das vorderseitige Kontaktsystem, nicht anwendbar.

Im Gegensatz hierzu liegen bei Dünnschicht-Solarmodulen mit einer einseitigen Serienverschaltung beide Kontaktsysteme zum getrennten Einsammeln der Ladungsträger auf einer gemeinsamen Seite der Absorberschicht. Dies hat zunächst grundsätzlich den Vorteil, dass nur eine Seite zur Kontaktierung bearbeitet werden muss. Im Sinne der vorliegenden Erfindung wird der Begriff "Vorderseitenkontaktierung" verwendet, wenn sich beide Kontaktsysteme auf der im Betrieb des Solarmoduls dem Lichteinfall ausgesetzten Seite ("Vorderseite") des Solarmoduls befinden. Der Begriff "Rückseitenkontaktierung" wird hingegen verwendet, wenn beide Kontaktsysteme auf der im Betrieb des Solarmoduls nicht dem Lichteinfall ausgesetzten Seite ("Rückseite") des Solarmoduls angeordnet sind. Wichtig bei der Anordnung der Kontaktsysteme ist in erster Linie ihre Effizienz bei der Ladungsträgersammlung. Im Falle einer pn-Konfiguration gilt: ist die Absorberschicht von hinreichend guter elektronischer Qualität, d.h. ist die effektive Bulk-Diffusionslänge der Minoritäts-Ladungsträger wesentlich größer als die Schichtdicke der Absorberschicht, so sollte die Emitterschicht in der Regel vorteilhafterweise auf der Rückseite des Dünnschicht-Solarmoduls liegen ("Rückseitenkontaktierung"). Hieraus ergeben sich dann insbesondere die Vorteile, dass erstens keine Abschattungs- oder Absorptionsverluste durch ein vorderseitiges Kontaktsystem auftreten, was zu einer Effizienzverbesserung führt, und dass zweitens eine einfache ganzflächige Bedeckung der im Betrieb des Solarmoduls dem Lichteinfall ausgesetzten Seite der Dünnschicht-Solarmoduls mit weiteren Funktionsschichten möglich ist. Hierbei kann es sich beispielsweise um Antireflex- oder Oberflächenpassivierungsschichten, aber auch um eine frontseitige Feldpassivierungsschicht (Front Surface Field FSF) zur Rückstreuung abgewanderter Ladungsträger handeln. Ist die Absorberschicht jedoch von relativ geringer elektronischer Qualität, d.h. ist die effektive Bulk-Diffusionslänge der Minoritäts-Ladungsträger in der Größenordnung oder kleiner als die Schichtdicke der Absorberschicht, so sollte die Emitterschicht vorteilhafterweise auf der Vorderseite des Moduls ("Vorderseitenkontaktierung") liegen. Alle Minoritäts-Ladungsträger der Absorberschicht, die in einer Tiefe generiert werden, die kleiner als die effektive Bulk-Diffusionslänge der Absorberschicht ist, können dann zuverlässig gesammelt werden. Bei der Vorderseitenkontaktierung kann zur effizienzverbessernden Ladungsrückstreuung eine rückseitige Feldpassivierungsschicht (Back Surface Field, BSF) vorgesehen sein (analog bei der Rückseitenkontaktierung eine frontseitige Feldpassivierungsschicht (Front Surface Field, FSF)). Eine Vorderseitenkontaktierung bedingt jedoch unvermeidbare nachteilige Absorptions- oder Abschattungsverluste durch die vorderseitigen Kontaktsysteme. Im Falle einer pin-Konfiguration gelten analoge Überlegungen in einer etwas abgeschwächten Form.

Bisher sind jedoch einseitenkontaktierte Dünnschicht-Solarmodule kaum realisiert worden, was insbesondere mit dem durch eine Einseitenkontaktierung bislang bedingten erhöhten Strukturierungsaufwand und mit einer damit kompatiblen Serienverschaltung im Dünnschicht-Solarmodul zusammenhängt. Das einzig bekannte und industriell umgesetzte einseitig (rückseitig) kontaktierte Dünnschicht-Solarmodul verwendet eine speziell entwickelte Serienverschaltung ("Doppelpunktkonzept").

### STAND DER TECHNIK

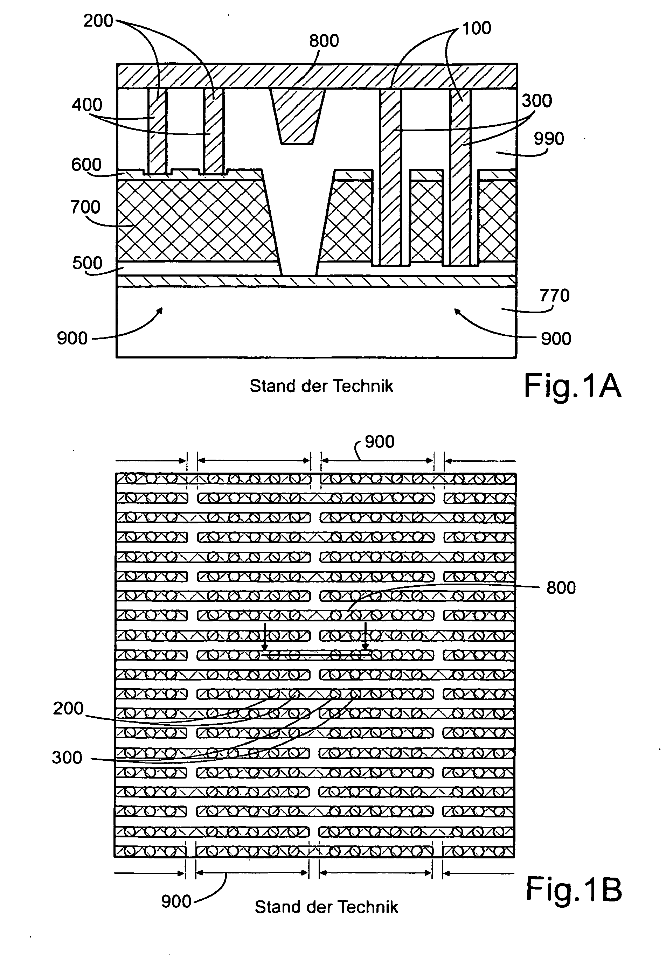

Die vorliegende Erfindung geht von dem aus der WO 03/019674 A1 bekannten Dünnschicht-Solarmodul mit einer rückseitigen Ausbildung beider Kontaktsysteme (vergleiche **FIGUREN 1A, 1** **B ZUM STAND DER TECHNIK,** im weiteren "Doppelpunktkonzept" genannt) als nächstliegendem Stand der Technik aus (vergleiche auch die **Veröffentlichung I** von P.A. Basore: "Simplified Processing and Improved Efficiency of Crystalline Silicon on Glass Modules", Proc. EPVSEC-19, Paris, France, June 2004). Bei diesem Doppelpunktkonzept sind beide rückseitige Kontaktsysteme mit punktförmigen Kontaktierungen unterschiedlicher Strukturierung ausgebildet. Um die überschüssigen Ladungsträger effizient sammeln zu können, sind somit Strukturgrößen erforderlich, die bedeutsam kleiner als die effektive Diffusionslänge der Absorberschicht sind. Bei einer schlechteren Absorberqualität sind somit sehr kleine Strukturgrößen nötig. Diese können derzeit - wenn überhaupt - technologisch nur sehr aufwändig, beispielsweise durch Photolithographie, realisiert werden. Um die effektive Diffusionslänge so groß wie möglich zu gestalten, wird beim dem bekannten Doppelpunktkonzept deshalb auch rekristallisiertes Silizium für die Absorberschicht verwendet, das eine für Dünnschicht-Solarmodule verhältnismäßig hohe effektive Diffusionslänge aufweist. Somit können bei dem bekannten Doppelpunktkonzept nur Absorber mit großen Diffusionslängen eingesetzt werden.

Bei dem bekannten Doppelpunktkonzept werden die verschieden ausgeführten punktförmigen Kontaktierungen beider Kontaktsysteme miteinander serienverschaltet. Dies bedingt eine Kontaktierung der streifenförmigen Solarzellenbereiche ausschließlich über Punktkontakte. Hierbei steigt jedoch der Strukturierungsaufwand an, da zwei verschiedenartige Punktkontaktierungen realisiert werden müssen. Weiterhin ergeben sich bei dem bekannten Doppelpunktkonzept auch Probleme bei der Ausrichtung der gefertigten Dünnschicht-Solarmodule während des Produktionsprozesses zur Serienverschaltung. Es besteht das technologisch äußerst schwierig zu beherrschende Problem des Alignments kleiner Strukturen auf großen Flächen, da die unterschiedlichen punktförmigen Kontaktierungen auf großen Flächen exakt zueinander ausgerichtet sein müssen, um sie elektrisch verbinden zu können.

Ausschließlich auf dem Gebiet der waferbasierten (Dickschicht-)Solarzellen-Technologie ist die DE 11 2005 002 592 T2 bekannt, bei der für einen Absorberwafer eine Rückseitenkontaktierung mit einem ersten Kontaktsystem mit punktförmigen Kontaktierungen und einer äußeren Kontaktschicht und einem zweiten Kontaktsystem mit ausschließlich einer flächigen, inneren Kontaktschicht für eine pn-Konfiguration mit einer rückseitig angeordneten Emitterschicht beschrieben wird. Beide Kontaktsysteme liegen auf der emitterzugewandten Seite des Absorberwafers übereinander und sind durch eine Isolationsschicht elektrisch voneinander getrennt. Der Absorberwafer wird punktförmig durch das erste Kontaktsystem, die Emitterschicht wird flächig kontaktiert. Die praktische Umsetzung dieses Konzepts ausschließlich für waferbasierte (Dickschicht-)Solarzellen ist aus der **Veröffentlichung II** von R.Stangl et al. "Planar Rear Emitter Back Contact Amorphous/Crystalline Silicon Heterojunction Solar Cells (RECASH/PRECASH)" (Paper IEEE-PVSEC-33. Konf., San Diego, USA, 12.-16.05.08, eingereicht 08.05.2008) bekannt. Beiden Veröffentlichungen sind jedoch keine Informationen über eine mögliche Modulverschaltung zu entnehmen. Grundsätzlich sind aber die in der Wafertechnologie vorgestellten Kontaktierungs- und Modulverschaltungskonzepte nicht ohne weiteres in die Dünnschichttechnologie übertragbar, weil sich die elektronischen Verhältnisse in der Absorberschicht und damit die Randbedingungen und Anforderungen für die die Ladungsträger sammelnden Kontaktsysteme grundlegend unterscheiden. Hierin ist auch der Grund zu sehen, warum bislang keine kostengünstigen und effizienten Kontaktierungssysteme für Dünnschicht-Solarmodule am Markt verfügbar sind.

### AUFGABENSTELLUNG

Die **AUFGABE** für die vorliegende Erfindung ist gegenüber der oben gewürdigten WO 03/019674 A1 darin zu sehen, ein einseitig kontaktiertes Dünnschicht-Solarmodul der gattungsgemäßen, eingangs beschriebenen Art anzugeben, bei dem sich keine Alignmentprobleme bei der seriellen Modulverschaltung ergeben und die erforderlichen Strukturierungsmaßnahmen grundsätzlich technisch beherrschbar und auf ein Minimum reduziert sind. Weiterhin sollen gleichermaßen pn-Konfigurationen und pin-Konfigurationen mit extrem kleinen Strukturgrößen technisch realisierbar sein. Dies soll sowohl für homogene als auch für heterogene Materialsysteme und sowohl für eine Vorderseitenkontaktierung als auch für eine Rückseitenkontaktierung bei Superstrat- und Substrataufbauten gelten. Die erfindungsgemäße LÖSUNG für diese Aufgabe ist dem Hauptanspruch zu entnehmen. Aufgezeigt wird auch ein bevorzugtes Herstellungsverfahren für das beanspruchte Dünnschicht-Solarmodul. Vorteilhafte Weiterbildungen sind den jeweiligen Unteransprüchen zu entnehmen und werden im Folgenden im Zusammenhang mit der Erfindung näher erläutert.

Bei dem erfindungsgemäßen Dünnschicht-Solarmodul besteht das zweite Kontaktsystem ausschließlich aus einer inneren Kontaktschicht, die die gesamte trägerschichtabgewandte Seite der Dünnschicht-Solarzellenbereiche flächig zusammenhängend überdeckt und lediglich Strukturierungen (im Sinne von Aussparungen wie Löchern, Schlitzen etc.) für die Kontaktierungen des ersten Kontaktsystems aufweist. Aus der inneren Kontaktfläche herausragende, dem Erreichen tiefer liegender Funktionsschichten dienende Kontaktierungen, die wiederum Strukturierungen in den zwischen liegenden Funktionsschichten erforderlich machen würden, sind nicht vorhanden. Folglich entfallen bei der Erfindung die dafür vorzusehenden Strukturierungsschritte völlig. Die Kontaktschicht des ersten Kontaktsystems ist als äußere Kontaktschicht ausgebildet, überdeckt das gesamte Dünnschichtpaket und erfasst alle Kontaktierungen. Diese greifen elektrisch isoliert durch die Strukturierungen in der inneren Kontaktschicht hindurch. Die innere Kontaktschicht und die äußere Kontaktschicht sind übereinander liegend angeordnet. Außerhalb der Verschaltungsbereiche sind die beiden Kontaktschichten mittels Zwischenlage einer Isolationsschicht elektrisch gegeneinander isoliert. Innerhalb der Verschaltungsbereiche sind sie mittels Serienkontakte miteinander elektrisch leitend verbunden.

Das erfindungsgemäße Dünnschicht-Solarmodul setzt damit erstmals technisch konsequent für ein Dünnschichtsystem eine einseitige Kontaktierung mit einem punktuellen ersten Kontaktsystem und einem flächigen zweiten Kontaktsystem um. Durch das Entfallen eines zweiten punktuellen Kontaktsystems verringert sich gegenüber dem bekannten Doppelpunktkonzept der Strukturierungsaufwand erheblich. Bei der Erfindung ist nurmehr ein Strukturierungsschritt erforderlich. Es wird die innere Kontaktschicht des zweiten Kontaktsystems strukturiert, um die Kontaktierungen des ersten Kontaktsystems auszubilden. Alignmentprobleme bei der Modulverschaltung treten nicht auf, da nunmehr die punktuellen Kontaktierungen mit einer flächigen Kontaktschicht verbunden werden.

Zur Umsetzung der Erfindung weist das zweite Kontaktsystem ausschließlich eine innere Kontaktschicht auf, die zwischen der Absorberschicht und der äußeren Kontaktschicht des ersten Kontaktsystems angeordnet ist und - je nach Aufbau des Dünnschichtpakets - der Kontaktierung der Absorberschicht selbst, aber auch jeder anderen ladungsträgerführenden Funktionsschicht dienen kann. Außerdem sind die beiden Kontaktsysteme mittels einer die gesamte Dünnschicht-Solarzellenfläche flächig überdeckenden Isolationsschicht außerhalb der Verschaltungsbereiche elektrisch gegeneinander isoliert. Nach einer gemeinsamen Strukturierung der inneren Kontaktschicht des zweiten Kontaktsystems gemeinsam mit der Isolationsschicht sowie den Funktionsschichten im Dünnschicht-Solarmodul können dann weitere Funktionsschichten sowie die äußere Kontaktschicht des ersten Kontaktsystem ohne jede weitere Strukturierung aufgebracht werden. Die Serienverschaltung der vorzugsweise streifenförmig ausgebildeten einzelnen Dünnschicht-Solarzellenbereiche im Modul ist hierbei in die Strukturierung bereits integriert. Mit beiden Kontaktsystemen können durch entsprechende Anordnung der Kontaktschichten und Ausführung der Kontaktierungen sowie durch Vorsehen von Durchkontaktierungen (Verlängerungen der Kontaktierungen durch die Absorberschicht) je nach Ausführung der Trägerschicht, der Anordnung der Funktionsschichten, der Ausführung der Konfiguration (pn oder pin) jede Art von Funktionsschicht (Emitterschicht, Feldpassivierungsschicht BSF oder FSF, Absorberschicht, Dotierschichten gegensätzlicher Dotierung und intrinsische Schicht) kontaktiert werden.

Es wird mit der Erfindung ein einseitenkontaktiertes Dünnschicht-Solarmodul mit einer einseitigen Serienverschaltung vorgestellt, bei der Kontaktierungen des ersten Kontaktsystems mit der Kontaktschicht des zweiten Kontaktsystems zwischen benachbarten Dünnschicht-Solarzellenbereichen in äußerst einfacher Weise serienverschaltet sind. Für die Modulverschaltung werden dabei nur elektrische Serienkontakte sowie linienförmig oder mäanderförmig gestaltete Isoliergräben benötigt. Ein derart einfach verschaltetes einseitenkontaktiertes Dünnschicht-Solarmodul weist gegenüber allen bekannten einseitigen Modulverschaltungen einen erheblich geringeren Strukturierungsaufwand auf. Zudem entfällt das Problem des Alignments kleiner Strukturen auf großen Flächen, da keine verschiedenartigen Punktkontaktierungen zueinander ausgerichtet werden müssen. Im Vergleich zu der bisher bei nahezu allen anderen Dünnschicht-Solarmodulen eingesetzten konventionellen Verschaltung beidseitiger Kontaktsysteme wird außerdem der ineffiziente Totbereich im Modul deutlich reduziert. Im Falle einer Rückseitenkontaktierung können bei der Erfindung die Absorptions- oder Abschattungsverluste des vorderseitigen, d.h. dem Lichteinfall zugewandten Kontaktsystems vollständig vermieden werden. Zudem werden auch Durchkontaktierungen durch die Absorberschicht zu darunter liegenden Funktionsschichten prozesstechnisch wesentlich erleichtert. Bei vorderseitiger Anordnung der Kontaktsysteme sind die Kontaktflächen transparent bzw. gitterförmig und die Kontaktierungen flächenminimiert, insbesondere punkt- oder linienförmig, auszuführen.

Bevorzugt sind zur Serienverschaltung der Dünnschicht-Solarzellenbereiche die Serienkontakte linienförmig ausgebildet. Dabei ist dann die äußere Kontaktschicht des ersten Kontaktsystems in den Verschaltungsbereichen durch linienförmige Isoliergräben strukturiert. Alternativ können die Serienkontakte auch punktförmig ausgebildet sein, wobei die äußere Kontaktschicht des ersten Kontaktsystems in den Verschaltungsbereichen dann durch meanderförmigen Isoliergräben strukturiert ist. Weiterhin können die Kontaktierungen des ersten Kontaktsystems und die Strukturierungen der inneren Kontaktschicht des zweiten Kontaktsystems bevorzugt punkt- oder linienförmig ausgebildet sein.

Bei dem Dünnschicht-Solarmodul nach der Erfindung kann sowohl eine Rückseitenkontaktierung ausgebildet werden, wenn die Trägerschicht als Superstrat ausgebildet ist und die beiden Kontaktsysteme auf der dem Lichteinfall abgewandten Seite des Dünnschicht-Solarmoduls angeordnet sind, als auch eine Vorderseitenkontaktierung ausgebildet werden, wenn die Trägerschicht als Substrat ausgebildet ist und die beiden Kontaktsysteme auf der dem Lichteinfall zugewandten Seite des Dünnschicht-Solarmoduls angeordnet sind. Eine Superstratausführung mit Vorderseitenkontaktierung bzw. eine Substratausführung mit Rückseitenkontaktierung bedingt eine Anordnung der Kontaktsysteme zwischen der Absorberschicht und der Trägerschicht. Diese Ausführungsformen sind zwar technisch realisierbar, in der Anwendung jedoch weniger interessant. Weiterhin kann eine pn-Konfiguration mit einer dotierten Absorberschicht und zumindest einer gegendotierten Emitterschicht als Dotierschicht zur Trennung der durch Lichteinfall in der Absorberschicht erzeugten überschüssigen Ladungsträger umgesetzt werden. Dabei können dann die Absorberschicht oder eine zugehörige ladungsträgerführende Funktionsschicht über die die darüber liegenden Schichten isoliert durchdringenden Kontaktierungen des ersten Kontaktsystems und die Emitterschicht oder eine zugehörige ladungsträgerführende Funktionsschicht mit der inneren Kontaktschicht des zweiten Kontaktsystems kontaktiert sein. Eine umgekehrte Zuordnung ist genauso möglich. Weiterhin ist bei einer pn-Konfiguration die Emitterschicht entweder auf der dem Lichteinfall zu- oder abgewandten Seite des Dünnschicht-Solarmoduls angeordnet. Zum anderen kann bei dem Dünnschicht-Solarmodul nach der Erfindung auch besonders vorteilhaft eine pin-Konfiguration mit einer intrinsischen oder schwach dotierten Absorberschicht und zumindest zwei Dotierschichten gegensätzlicher Dotierung beiderseits der Absorberschicht zur Trennung der durch Lichteinfall in der Absorberschicht erzeugten überschüssigen Ladungsträger umgesetzt werden. Dann kann eine der beiden Dotierschichten oder eine zugehörige ladungsträgerführende Funktionsschicht über die die darüber liegenden Schichten isoliert durchdringenden Kontaktierungen des ersten Kontaktsystems und die andere Dotierschicht oder eine zugehörige ladungsträgerführende Funktionsschicht mit der inneren Kontaktschicht des zweiten Kontaktsystems kontaktiert sein. Weitere Einzelheiten zu möglichen Ausführungsformen sind dem speziellen Beschreibungsteil zu entnehmen.

In anderen Ausführungsformen des Dünnschicht-Solarmoduls nach der Erfindung können noch vorteilhaft als zumindest ein weitere Funktionsschicht eine Antireflexschicht, Saatschicht, Oberflächenpassivierungsschicht, Feldpassivierungsschicht, Leitschicht und/oder Pufferschicht vorgesehen sein. Darüber hinaus können sowohl Homoausführungen, bei der die zumindest eine Dotierschicht aus zum Halbleitermaterial der Absorberschicht gleichem Halbleitermaterial, als auch Heteroausführungen mit unterschiedlichem Halbleitermaterial realisiert werden. Materialtechnisch können bevorzugt die die Absorberschicht aus kristallinem Silizium (c-Si) oder aus polykristallinem Silizium (poly-Si), die Emitterschicht oder Dotierschichten aus wasserstoffangereichertem amorphem Silizium (a-Si:H) oder aus polykristallinem Silizium (poly-Si), Feldpassivierungsschichten aus wasserstoffangereichertem amorphem Silizium (a-Si:H), Pufferschichten aus intrinsischem amorphem Silizium (i-a-Si), die Isolationsschicht aus Harz oder Siliziumoxid, die Leitschicht aus transparentem, leitfähigem Oxid (TCO) oder Molybdän, Oberflächenpassivierungs-, Reflexions- und Antireflexschicht aus Siliziumnitrid (SiN), das Superstrat oder Substrat aus Glas und die Kontaktsysteme aus Aluminium oder aus transparentem, leitfähigem Oxid (TCO) bestehen.

Bei einem bevorzugten Verfahren zur Herstellung des zuvor beschrieben einseitig kontaktierten Dünnschicht-Solarmoduls nach der Erfindung in seinen unterschiedlichen Ausführungsformen kann das erste Kontaktsystem mit seinen Kontaktierungen und seiner äußeren Kontaktschicht hergestellt werden durch
- Erzeugen von Strukturierungen im Dünnschichtpaket bis zu der zu kontaktierenden Dotier- oder Funktionsschicht mittels Bohren, Ätzen oder Laserablation,
- elektrisches Isolieren der Strukturierungen durch Einfließenlassen von flüssigem Isoliermaterial und
- ganzflächige, unstrukturierte Metallisierung der Oberfläche des Dünnschichtpakets und der Strukturierungen.

Dabei kann es sich bei dem fließfähigen isoliermaterial um Harz (Resin) handeln. Weiterhin kann vorteilhaft vor der Metallisierung noch eine ganzflächige, unstrukturierte Abscheidung einer weiteren Funktionsschicht durchgeführt werden. Alternativ können die Kontaktierungen des ersten Kontaktsystems und/oder die elektrischen Serienkontakte für die Serienverschaltung der Solarzellenbereiche auch durch Laserfeuern erzeugt werden.

### AUSFÜHRUNGSBEISPIELE

Das einseitig kontaktierte Dünnschicht-Solarmodul nach der Erfindung in seinen verschiedenen Ausführungsformen wird nachfolgend anhand von Ausführungsbeispielen in den schematischen, nicht maßstabsgerechten (alle Schichten aus Gründen der Darstellbarkeit in keinem maßstabsgerechten Verhältnis zueinander) **FIGUREN** zu Querschnitten und Aufsichten von Dünnschicht-Solarmodulen näher erläutert.

### ZUM STAND DER TECHNIK ZEIGT DIE

- **FIGUR 1A**: Doppelpunkt- Verschaltungskonzept zur rückseitigen Serienverschaltung von Dünnschicht-Solarmodulen in Querschnitt,
- **FIGUR 1B**: Doppelpunkt- Verschaltungskonzept zur rückseitigen Serienverschaltung von Dünnschicht-Solarmodulen gemäß **FIGUR 1A** in der Aufsicht

### ZUR ERFINDUNG ZEIGT DIE

- **FIGUR 2**: eine Ausführungsform mit rückseitiger Emitterschicht und Feldpassivierungsschicht,
- **FIGUR 3**: eine Ausführungsform mit rückseitiger Emitterschicht und Leitschicht,
- **FIGUR 4**: eine Ausführungsform mit rückseitiger Emitterschicht ohne Leitschicht,
- **FIGUR 5**: eine Ausführungsform mit vorderseitiger Emitterschicht ohne Leitschicht,
- **FIGUR 6**: eine Ausführungsform mit vorderseitiger Emitterschicht und Leitschicht,
- **FIGUR 7A**: eine Aufsicht mit linienförmigen Serienkontakten,
- **FIGUR 7B**: eine Aufsicht mit punktförmigen Serienkontakten und
- **FIGUREN 8A-J**: Herstellung eines Dünnschicht-Solarmoduls gemäß **FIG. 2**

Zum Stand der Technik ist in den FIGUREN 1 A (Querschnitt), 1 B (Aufsicht mit Schnittangabe) das bislang einzige technisch realisierte einseitige (rückseitige) Modulverschaltungskonzept in Dünnschichttechnik ("Doppelpunktkonzept") gemäß der in der Beschreibungseinleitung bereits gewürdigten WO 03/019674 A1 für eine technisch realisierbare pn-Konfiguration mit Superstratausführung dargestellt. Ein rückseitiges erstes Kontaktsystem 100 und ein rückseitiges zweites Kontaktsystem 200 weisen beide Punktkontakte 300, 400 zur Kontaktierung einer Emitterschicht 500 und einer Feldpassivierungsschicht 600 beiderseits einer Absorberschicht 700 auf einem Superstrat 770 auf. Die Punktkontakte 300, 400 sind zueinander ausgerichtet und durch schmale Kontaktstreifen **800** so mit einander elektrisch leitend verbunden, dass sich eine Serienverschaltung der streifenförmigen Solarzellenbereiche **900** ergibt. Ansonsten sind die beiden Kontaktsysteme **100, 200** durch eine Isolationsschicht **990** elektrisch gegeneinander isoliert.

Alle FIGUREN zur Erfindung zeigen Superstratkonfigurationen, bei denen der Lichteinfall durch das Superstrat als Trägerschicht hindurch erfolgt. Substratkonfigurationen sind jedoch in ihrem Dünnschichtpaketaufbau identisch mit den gezeigten Superstratkonfigurationen. Das Licht fällt bei Substratkonfigurationen durch die beiden Kontaktsysteme und nicht mehr durch die Trägerschicht in das Dünnschichtpaket ein. Folglich müssen die beiden Kontaktsysteme sowie die Isolationsschicht transparent ausgeführt sein. Beide Kontaktsystem können beispielsweise aus transparentem leitfähigen Oxid (TCO) sein, die Isolationsschicht kann - anstelle von Harz - beispielsweise aus transparentem Siliziumoxid (SiO₂) oder Siliziumnitrid (SiN) bestehen. Im Gegenzug muss nun allerdings nicht mehr die isolierende Passivierungsschicht bzw. die Leitschicht notwendigerweise transparent ausgeführt sein, wie dies bei der Superstratkonfiguration erforderlich ist. Somit kann die Leitschicht bei der Substratkonfiguration beispielsweise anstelle aus leitfähigem Oxid aus Metall sein.

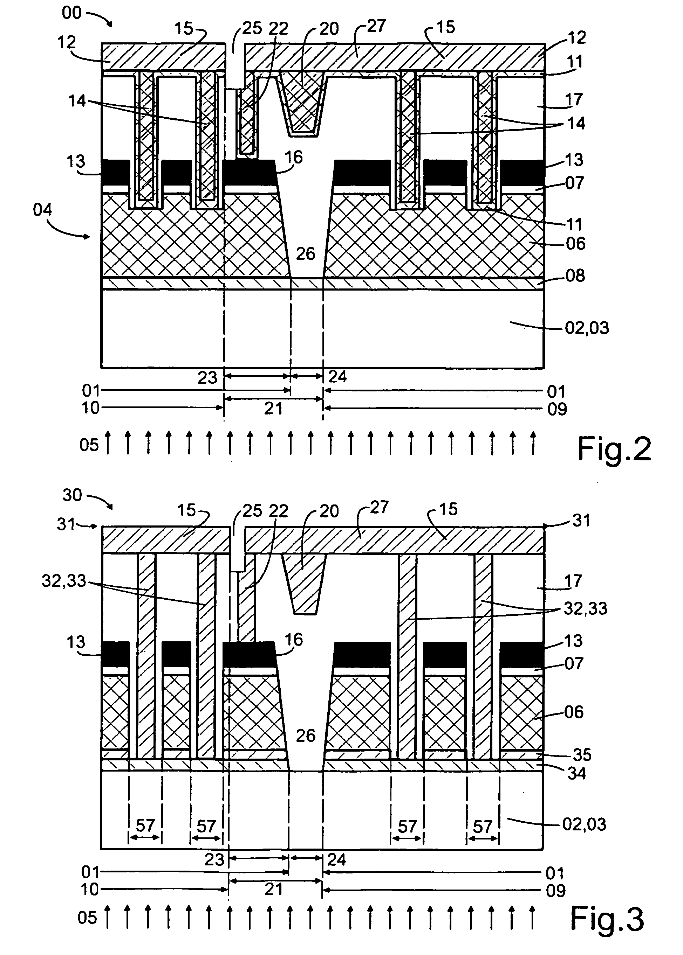

Des Weiteren zeigen die FIGUREN 2 bis 8 pn-Konfigurationen. Es können jedoch alle gezeigten Ausführungsformen in entsprechender Weise jeweils auch als pin-Konfiguration ausgeführt werden, da das Kontaktierungsschema nach außen identisch ist. Es werden nur jeweils andere Funktionsschichten im Dünnschichtpaket vom ersten und zweiten Kontaktsystem kontaktiert. Die gezeigten Emitter- und Feldpassivierungsschichten in pn-Konfigurationen entsprechen den Ladungsträger (Elektronen n-typ, Löcher p-typ) sammelnden Dotierschichten in pin-Konfigurationen, die Absorberschicht ist dann nicht stark dotiert, sondern undotiert (intrinsisch) oder nur gering dotiert. Alle Dotierschichten können beispielsweise als Einzelschicht aus dotiertem a-Si:H oder aus einer Doppelschicht aus intrinsischem und dotiertem a-Si:H bestehen. Die intrinsische Schicht erfüllt dann die Funktion einer Pufferschicht (nicht dargestellt). In den **FIGUREN** nachfolgend nicht gezeigte oder beschriebene Bezugszeichen sind den vorangehenden Figuren und Beschreibungen zu entnehmen.

Die **FIGUR 2** zeigt ein serienverschaltetes Dünnschicht-Solarmodul **00** aus streifenförmigen Solarzellenbereichen **01** in pn-Konfiguration. Eine Trägerschicht **02** ist als Superstrat **03** ausgebildet, die oberhalb eines Dünnschichtpakets **04** liegt. Der Lichteinfall **05** erfolgt durch das Superstrat **03** hindurch. Dargestellt ist eine Absorberschicht **06,** an die eine Emitterschicht **07** angrenzt. Diese kann als Einzel- oder als Doppelschicht ausgebildet sein (s.o.). Bezüglich des Lichteinfalls **05** ist die Emitterschicht **07** auf der Rückseite der Absorberschicht **06** angeordnet. Auf der Vorderseite, d.h. zwischen der Absorberschicht **06** und dem Superstrat **03** befindet sich eine elektrisch isolierende, transparente Oberflächenpassivierungsschicht **08**, beispielsweise aus SiN, welche optional ist. Weiterhin ist eine elektrisch leitende Feldpassivierungsschicht **11** (rückseitig BSF) vorgesehen. Diese kann wiederum als Einzel- oder Doppelschicht ausgebildet sein (s.o.). Die Feldpassivierungsschicht **11** ist jedoch ebenfalls optional.

Gezeigt sind in der **FIGUR 2** ein erstes Kontaktsystem **12** und ein zweites Kontaktsystem **13,** die beide auf der Rückseite des Dünnschicht-Solarmoduls **00** (bezogen auf den Lichteinfall **05**) angeordnet sind und dementsprechend nicht transparent ausgeführt sein müssen. Das erste Kontaktsystem **12** besteht aus zumeist punkt- oder linienförmigen Kontaktierungen **14** und einer flächig oder gitterförmig ausgebildeten äußeren Kontaktschicht **15.** Die punkt- oder linienförmigen Kontaktierungen **14** kontaktieren die Absorberschicht **06** an ihrer vom Lichteinfall **05** abgewandten Seite und sind dementsprechend nicht als Durchkontaktierungen ausgebildet. Das zweite Kontaktsystem **13** besteht hingegen einzig aus einer flächig ausgebildeten, inneren Kontaktschicht **16,** die zur Durchführung der punkt- oder linienförmigen Kontaktierungen **14** des ersten Kontaktsystems **12** entsprechend strukturiert ist. Zwischen dem ersten Kontaktsystem **12** und dem zweiten Kontaktsystem **13** ist eine Isolationsschicht **17** angeordnet.

Im Dünnschicht-Solarmodul **00** ist ein durch eine Serienverschaltung **20** der Solarzellenbereiche **01** definierter Verschaltungsbereich **21** dargestellt. Innerhalb dieses Verschaltungsbereichs **21** ist die in den Verschaltungsbereich **21** hineinreichende äußere Kontaktschicht **15** des ersten Kontaktsystems **12** eines auf der einen Seite an den Verschaltungsbereich **21** angrenzenden Solarzellenbereichs **09** mit der in den Verschaltungsbereich **21** hineinreichen**den** inneren Kontaktschicht **16** des zweiten Kontaktsystems eines auf der anderen Seite an den Verschaltungsbereich **21** angrenzenden Solarzellenbereichs **10** mittels Serienkontakten **22** elektrisch leitend verbunden. Außerhalb des Verschaltungsbereichs **21** sind die beiden Kontaktsysteme **12, 13** durch die Isolationsschicht **17** elektrisch gegeneinander elektrisch isoliert. Die Serienkontakte **22** definieren im Verschaltungsbereich **21** einen Kontaktbereich **23.** Daneben befindet sich im Verschaltungsbereich **21** ein Totbereich **24,** der bei dem Verschaltungskonzept nach der Erfindung besonders klein ist. Weiterhin ist innerhalb des Verschaltungsbereichs **21** ein Isoliergraben **25** zur Unterbrechung der äußeren Kontaktschicht **15** des ersten Kontaktsystems **12** und damit zur elektrischen Isolation der benachbarten Solarzellenbereiche **09, 10** vorgesehen. Das Dünnschichtpaket **04** wird durch Trenngräben **26** in die streifenförmigen Solarzellenbereiche **01** unterteilt.

Die **FIGUR 3** zeigt eine Ausbildung eines Dünnschicht-Solarmoduls **30** mit einem ersten Kontaktsystem **31,** dessen Kontaktierungen **32** als Durchkontaktierungen **33** durch die Absorberschicht **06** hindurch ausgebildet sind. Die Durchkontaktierungen **33** kontaktieren im gezeigten Ausführungsbeispiel eine transparente Leitschicht **34,** beispielsweise TCO. Zwischen der Absorberschicht **06** und dem Superstrat **03** ist eine strukturierte transparente leitende Feldpassivierungsschicht **35** (FSF) angeordnet. Aufgrund der Durchkontaktierungen **33** ergeben sich in der photoaktiven Absorberschicht **06** neben dem Totbereich **24** im Verschaltungsbereich **21** noch weitere Totbereiche **57.**

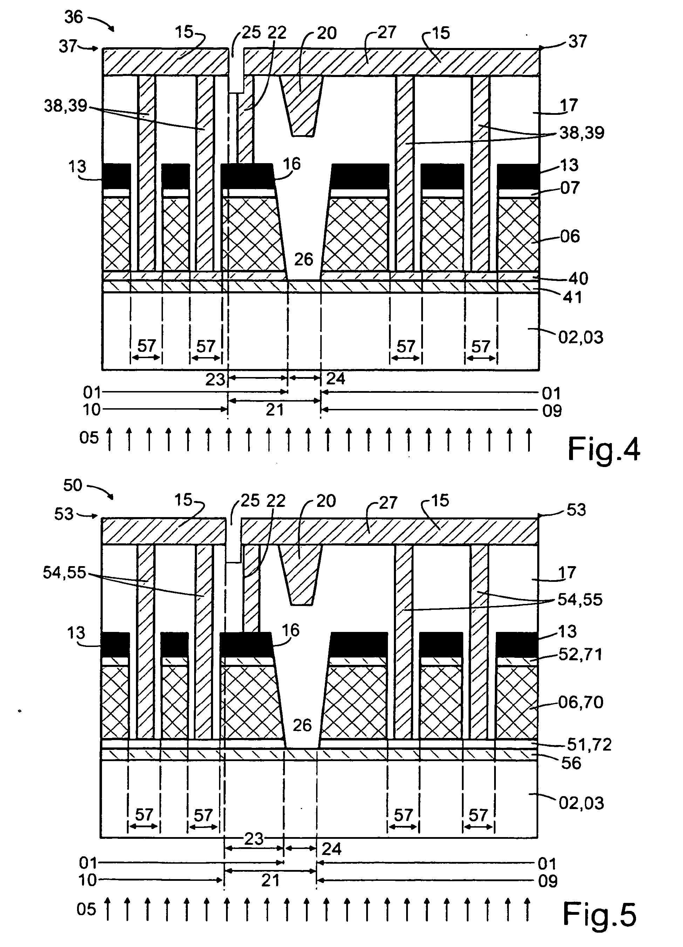

Die **FIGUR 4** zeigt eine Ausbildung eines Dünnschicht-Solarmoduls **36** mit einem ersten Kontaktsystem **37,** dessen Kontaktierungen **38** als Durchkontaktierungen **39** durch die Absorberschicht **06** hindurch ausgebildet sind und eine unstrukturierte transparente leitende Feldpassivierungsschicht **40** (FSF) kontaktieren. Zwischen der Absorberschicht **06** und dem Superstrat **03** ist eine isolierende transparente Oberflächenpassivierungsschicht **41** angeordnet. Diese ist optional, da bereits die Feldpassivierungsschicht **40** vorhanden ist. Aufgrund der Durchkontaktierungen **39** ergeben sich in der photoaktiven Absorberschicht **06** neben dem Totbereich **24** im Verschaltungsbereich **21** noch weitere Totbereiche **57.**

In der **FIGUR 5** ist ein Dünnschicht-Solarmodul **50** dargestellt, bei dem eine unstrukturierte Emitterschicht **51** auf der bezüglich des Lichteinfalls vorgesehenen Vorderseite der Absorberschicht **06** angeordnet ist. Auf der Rückseite der Absorberschicht **06** ist nunmehr eine strukturierte Feldpassivierungsschicht **52** (BSF) vorgesehen. Das erste Kontaktsystem **53** weist Kontaktierungen **54** auf, die als Durchkontaktierungen **55** die unstrukturierte Emitterschicht **51** kontaktieren. Unterhalb der unstrukturierten Emitterschicht **51** ist eine elektrisch isolierende transparente Oberflächenpassivierungsschicht **56** angeordnet, die jedoch optional ist. Bei einer Anordnung der Emitterschicht **51** auf der bezüglich des Lichteinfalls **05** liegenden Vorderseite der Absorberschicht **06** ergeben sich jedoch neben dem Totbereich **24** im Verschaltungsbereich **21** noch weitere Totbereiche **57** außerhalb des Verschaltungsbereichs **21.**

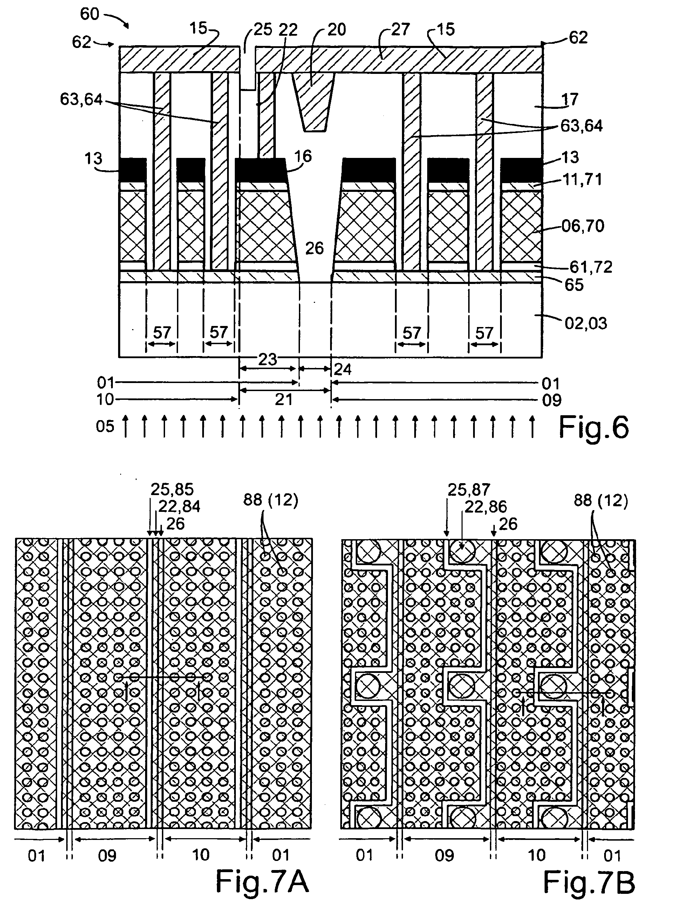

Die **FIGUR 6** zeigt ein Dünnschicht-Solarmodul **60** mit einer strukturierten Emitterschicht **61** auf der Vorderseite der Absorberschicht **06.** Das erste Kontaktsystem **62** weist Kontaktierungen **63** in Form von Durchkontaktierungen **64,** die eine unstrukturierte transparente Leitschicht 65 (TCO) kontaktieren.

In den **FIGUREN 2** bis **6** sind pn-Konfigurationen mit Absorberschicht **06** und Emitterschicht **07, 51, 61** dargestellt. Bei einer pin-Konfiguration wird eine intrinsische oder schwach dotierte Absorberschicht **70** zwischen zwei gegensätzlich dotierten Dotierschichten **71, 72** verwendet. Diese Schichten entsprechen je nach Dotierung der Emitter- und der Feldpassivierungsschicht beiderseits der Absorberschicht **06.** Die pin-Konfiguration ist durch Kennzeichnung der entsprechenden Schichten mit den Bezugszeichen **70, 71** und **72** beispielsweise in den **FIGUREN 5** und **6** angedeutet.

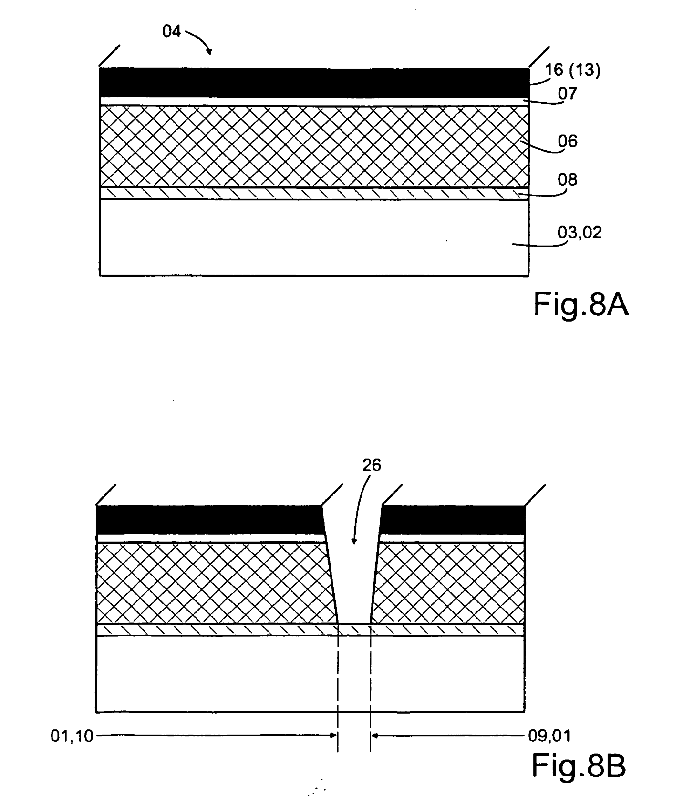

In den **FIGUREN 7A** und **7B** sind zwei mögliche Aufsichten auf Dünnschicht-Solarmodule **00** nach der Erfindung gezeigt (eingezeichnet sind die Schnittlinien für die Querschnittsansichten in den **FIGUREN 2** bis **6**). In der **FIGUR 7A** sind die Serienkontakte **22** in der Ausführung linienförmiger Serienkontakte **84** zur Serienverschaltung der beiden Kontaktsysteme **12, 13** benachbarter Solarzellenbereiche **09,10** dargestellt. Es ergeben sich Isoliergräben **25** in der Ausführung linienförmiger Isoliergräben **85.** In der **FIGUR 7B** sind die Serienkontakte **22** in der Ausführung punktförmiger Serienkontakte **86** zur Serienverschaltung der beiden Kontaktsysteme benachbarter Solarzellenbereiche **09,10** dargestellt. Es ergeben sich Isoliergräben **25** in der Ausführung mäanderförmiger Isoliergräben **87.** Jeweils daneben sind die linearen Trenngräben **26** zwischen den Solarzellenbereichen **09, 10** angedeutet. Angedeutet sind auch Kontaktierungen **14** des ersten Kontaktsystems **12** in der Ausführungsform von punktförmigen Kontaktierungen **88.** Insbesondere bei der Ausführungsform gemäß **FIGUR 7A** mit linienförmigen Serienkontakten **84** können auch die Kontaktierungen **14** auch als linienförmige Kontaktierungen ausgeführt sein (nicht weiter dargestellt). Diese genannten Ausführungsformen sind jeweils identisch für alle Übergänge zwischen den Solarzellenbereichen **01** und gelten für alle anderen Ausführungsformen von Dünnschicht-Solarmodulen nach der Erfindung. In den **FIGUREN 8A****...J** wird die Herstellung eines Dünnschicht-Solarmoduls **00** mit streifenförmig ausgebildeten Solarzellbereichen **01** gemäß **FIGUR 2** einschließlich integrierter Modulverschaltung beschrieben.

### (FIGUR 8A) Bereitstellung des Dünnschichtpakets 04:

Abscheiden des Dünnschichtpakets **04:** Superstrat **03** (z.B. Glas)/ (optionale) Passivierungsschicht **08** (z.B. 80 nm SiN)/ optionale Antireflex-Schicht (nicht dargestellt)/ optionale Feldpassivierungsschicht (BSF, nicht dargestellt) /optionale Leitschicht (nicht dargestellt) / Absorberschicht **06** (z.B. rekristallisiertes poly-Si, das über eine Temperung von amorph abgeschiedenem 2 µm a-Si:H erzeugt wurde) / Emitterschicht **07** (z.B. PECVDabgeschiedenes 30 nm a-Si:H) / metallische innere Kontaktschicht **16** des zweiten Kontaktsystems **13** (z.B. 500 µm elektronenstrahlverdampftes Al)

### (FIGUR 8B) Modul-Strukturierung:

Modul-Strukturierung des Dünnschichtpakets **04** in einzelne Solarzellenbereiche **09, 10** (hier Streifen), Erzeugung von Trenngräben **26**, z.B. durch mechanisches Kratzen oder Laser-Scribing.

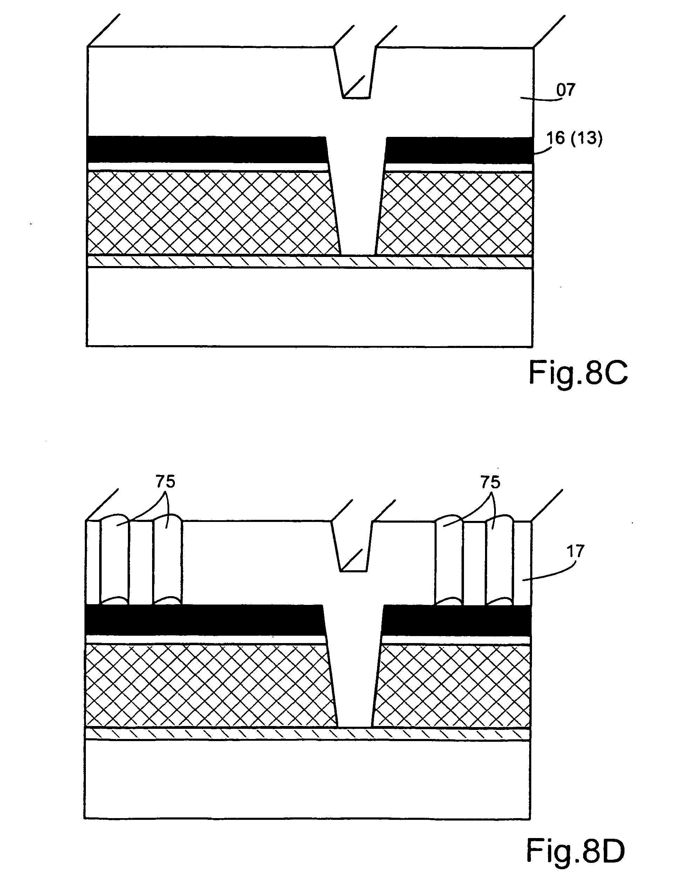

### (FIGUR 8C) Aufbringen der Isolationsschicht 17 (elektrische Isolierung des zweiten Kontaktsystems 13)

Auf der inneren Kontaktschicht **16** des zweiten Kontaktsystems **13** wird eine Isolationsschicht **17** abgeschieden. Dies geschieht entweder ganzflächig (z.B. durch PECVD-Abscheidung von SiO₂) und anschließender Strukturierung oder bereits durch strukturiertes Auftragen (z.B. Siebdruck, Inkjetdruck eines z.B. organischen Resins (Gießharz) bzw. von isolierenden Pasten).

### (FIGUR 8D) Punkt-Strukturierung der Isolationsschicht 17

Die rückseitig angeordnete Isolationsschicht **17** wird nun punktförmig strukturiert. Das heißt, in die Isolationsschicht **17** werden regelmäßig angeordnete Strukturierungen **75** (beispielsweise Löcher mit 100 µm Durchmesser) eingebracht. Die Strukturierung geschieht entweder bereits beim Auftragen der Isolationsschicht **17** selbst (z.B. durch Siebdruck/Inkjet-Druck der Isolationsschicht **17**) oder durch Inkjet-Druck einer Ätzlösung oder durch Siebdruck/Inkjetdruck einer Maskierungsschicht und einem nachfolgenden Ätzvorgang.

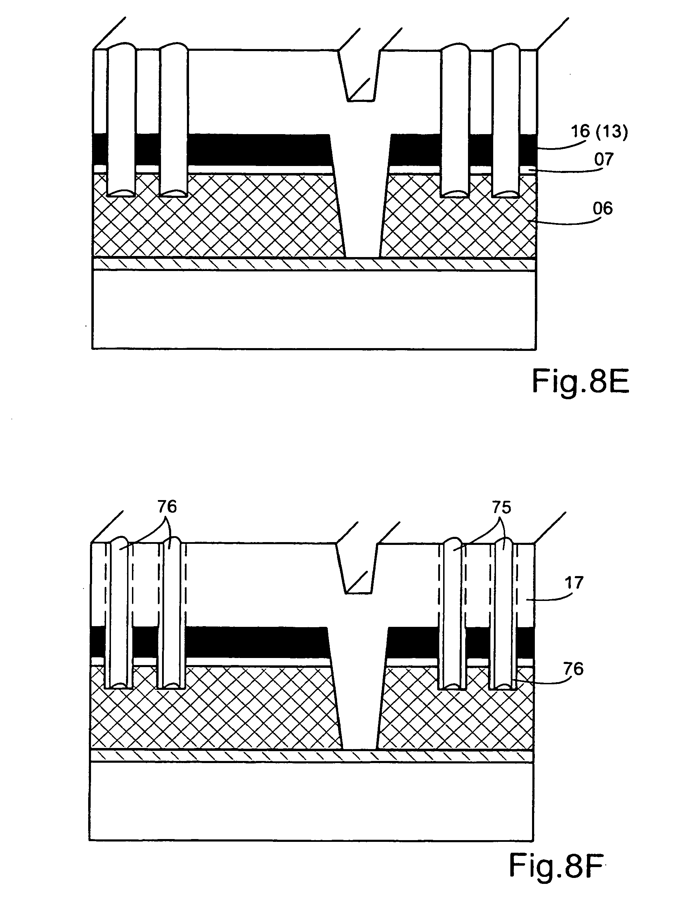

### (FIGUR 8E) punktförmiges Freilegen der Absorberschicht 06

Die nunmehr punktförmig strukturierte Isolationsschicht **17** dient nun als Maskierungsschicht, um über eine Ätzlösung die Rückseite der Absorberschicht **06** freizulegen. Sowohl die innere Kontaktschicht **16** des zweiten Kontaktsystems **13** als auch die Emitterschicht **07** werden punktförmig entfernt. Optional kann bei Vorhandensein einer Feldpassivierungsschicht (BSF) auch die Absorberschicht punktförmig entfernt werden, es entstehen dann Durchkontaktierungen.

Alternativ hierzu kann auch eine flächig angebrachte Isolationsschicht **17** mittels Laserstrukturierung schrittweise bis auf die Rückseite der Absorberschicht **06** freigelegt werden (schrittweise Laserbohrung von Strukturierungen **75** durch die Isolationsschicht **17,** die Kontaktschicht **16** des zweiten Kontaktsystems **13** und die Emitterschicht **07).**

### (FIGUR 8F) Innenisolierung der Strukturierungen 75

Die Innenseiten der hergestellten Strukturierungen **75** werden mit einer Isolationsauskleidung **76** bedeckt. Dies geschieht am einfachsten unter Verwendung eines organischen Gießharzes (Resin) als Isolationsauskleidung **76** durch kurzzeitige Temperung. Die Isolationsauskleidung **24** (Resin) verflüssigt sich dann und rinnt die Strukturierungen **75** herunter. Alternativ kann eine weitere Isolationsschicht ganzflächig auf die rückseitig angeordnete Isolationsschicht **17** aufgebracht (diese bedeckt dann die Isolationsschicht **17,** die Wandungen und die Böden der Strukturierungen **75**) und vermittels einer über Siebdruck/Inkjetdruck aufgebrachten Maskierungsschicht die Böden wieder freigelegt werden (ätzen). Das Material der Isolationsschicht **17** und der Isolationsauskleidung **76** kann identisch sein.

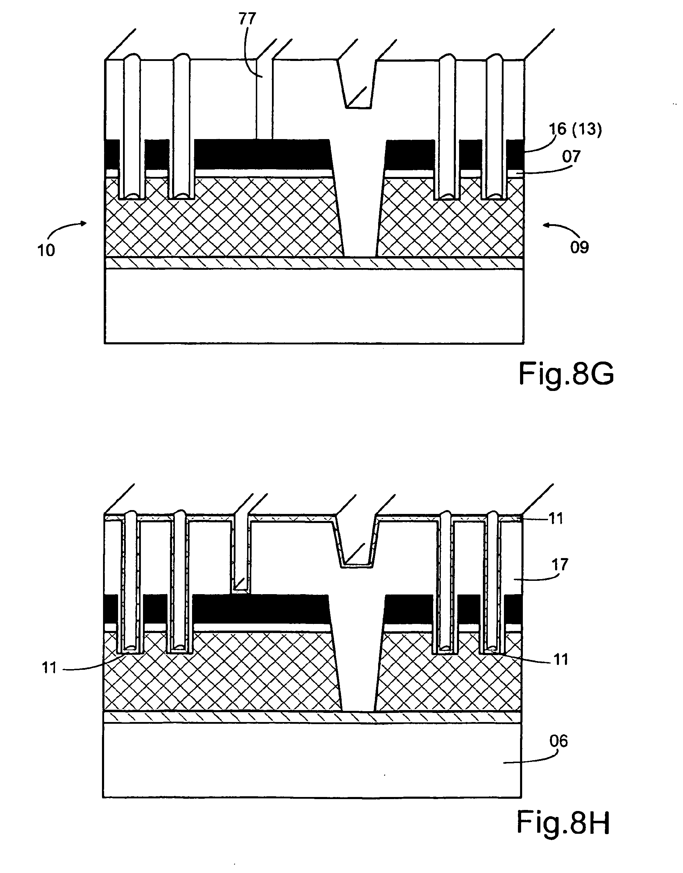

### (FIGUR 8G) Freilegen von Kontaktierungsöffnungen 77 für die späteren Serienkontakte 22 der Serienverschaltungen

Auf der Isolationsschicht **17** werden linienförmige Kontaktierungsöffnungen **77** (diese können auch punktförmig sein, vergleiche **FIGUR 7B**) zu der Kontaktschicht **16** (**13**) des zweiten Kontaktsystems **13** (hier Kontaktierung der Emitterschicht **07**) für die Serienkontakte **22** der Serienverschaltungen des Dünnschichtmoduls **00** freigelegt, analog zum Verfahrensschritt gemäß FIGUR **5d.** Alternativ kann auf die Freilegung verzichtet werden und die Serienkontakte **22** zwischen dem ersten Kontaktsystems **12** zum zweiten Kontaktsystem **13** zur seriellen Verbindung zwischen den benachbarten Solarzellenbereichen **09,10** später über lasergefeuerte Kontaktierung hergestellt werden.

### (FIGUR 8H) optionales, ganzflächiges, unstrukturiertes Abscheiden einer Feldpassivierschicht

Auf die rückseitig angeordnete, nunmehr strukturierte Isolationsschicht **17** wird optional eine Feldpassivierungsschicht **11** (z.B. PECVD abgeschiedenes 30 nm a-Si:H) abgeschieden. Diese bedeckt somit die Isolationsschicht **17** als auch die freigelegten Lochböden der Rückseite der Absorberschicht **12** und bildet damit Kontaktierungen **14** (hier punktförmig, analog auch linienförmig) zur Absorberrückseite aus.

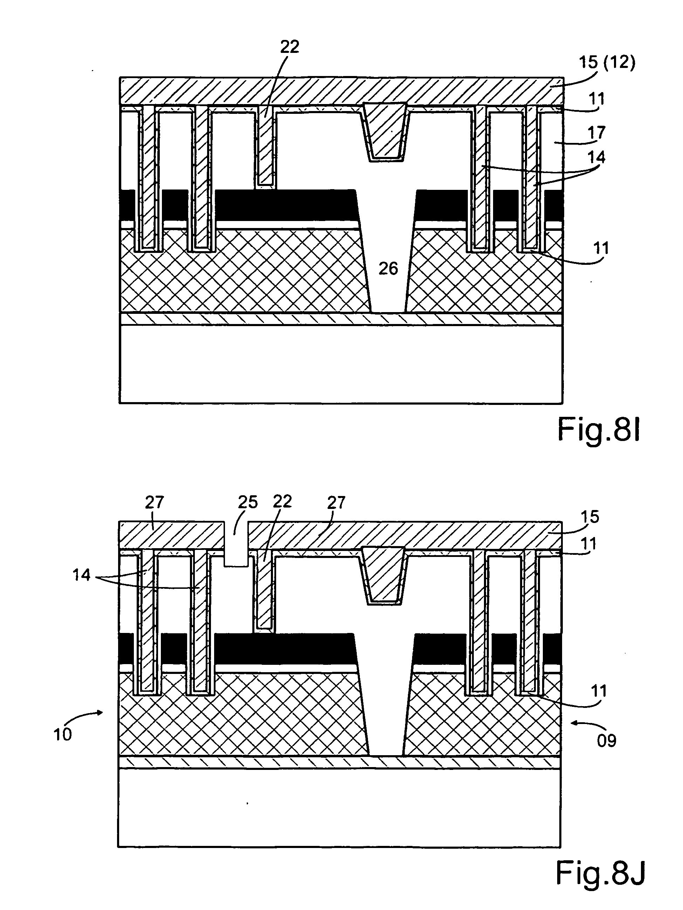

### (FIGUR 8I) unstrukturiertes ganzflächiges Abscheiden des ersten Kontaktsystems

Auf die optional abgeschiedene Feldpassivierungsschicht **11** bzw. auf die rückseitig angeordnete, strukturierte Isolationsschicht **17** wird die metallische äußere Kontaktschicht **15** des ersten Kontaktsystems **12** (z.B. elektronenstrahlverdampftes Al oder siebgedruckte/inkjetgedruckte metallische Pasten) abgeschieden. Die Kontaktschicht **15** bedeckt somit die Feldpassivierungsschicht **11** bzw. die Isolationsschicht **17.** Im Bereich der vorher angelegten Strukturen entstehen dabei automatisch die Kontaktierungen **14** und Serienkontakte **22,** ohne dass eigene aufwändige Strukturierungsschritte erforderlich sind: Die Befüllung des in der Isolationsschicht **17** abgebildeten Trenngrabens **26** ist dabei ohne Funktion.

### (FIGUR 8J) Auftrennung der äußeren Kontaktschicht des ersten Kontaktsystems

Zur Realisierung der Serienverschaltung der Solarzellenbereiche **09, 10** werden anschließend Isoliergräben **25** über Laserablation oder über einen Maskierungsvorgang mit anschließender Ätzung von der äußeren Kontaktschicht **15** und der optional abgeschiedenen Feldpassivierungsschicht **11** wieder weggenommen.

Alternativ kann die metallische äußere Kontaktschicht **15** auch gleich strukturiert abgeschieden werden (z.B. über sieb- oder inkjetgedruckte metallische Pasten), so dass die Kontaktierungen **14** Kontaktschichtabschnitte **27** kontaktieren, die in einer solchen Weise strukturiert flächig (streifen- bzw. gitterförmig) abgeschieden werden, dass sie alle zu einem Solarzellenbereich **09, 10** gehörenden Kontaktierungen **14** kontaktieren und jeweils ein Gittersteg des einen Solarzellenbereichs **10** die Serienkontakte **22** des benachbarten Solarzellenbereich 09 sammelt (in der **FIGUR 8J** nicht dargestellt). Wurde der Verfahrensschritt gemäß **FIGUR 8G** weggelassen, so muss nun im Anschluss z.B. über lasergefeuerte Kontaktierung die elektrisch leitende Verbindung des ersten Kontaktsystems **12** zum zweiten Kontaktsystem **13** hergestellt werden.

Die Herstellung einer Modulverschaltung mit einem Dünnschichtpaket mit pin-Struktur erfolgt in völlig analoger Weise, wobei im Dünnschichtpaket eine intrinsische oder schwach dotierte Absorberschicht und zwei gegensätzlich dotierte Dotierschichten eingebracht werden. Alle Beschichtungs- und Strukturierungsschritte werden in gleicher Weise zu den obigen Ausführungen durchgeführt. Der Aufbau des Dünnschichtpakets hat keinen Einfluss auf den grundsätzlichen Aufbau der Modulverschaltung mit den beiden Kontaktierungssystemen, die lediglich entsprechend unterschiedliche Schichten kontaktieren.

Im Vergleich der einseitigen flächig/punktförmigen seriellen Modulverschaltung nach der Erfindung gemäß **FIGUR 8J** mit einer aus dem Stand der Technik bekannten konventionellen, zweiseitig flächigen seriellen Modulverschaltung, bei der nahezu der gesamte Verschaltungsbereich auch gleichzeitig Totbereich ist, ergibt sich, dass bei der Erfindung der Totbereich bedeutsam kleiner ist. Dies hat einen höheren, flächenbezogenen Modulwirkungsgrad bei der Erfindung gegenüber konventionellen zweiseitigen Serienverschaltungen von Dünnschicht-Solarmodulen zur Folge.

### BEZUGSZEICHENLISTE

- **100**: erstes Kontaktsystem
- **200**: zweites Kontaktsystem
- **300**: Punktkontakt
- **400**: Punktkontakt
- **500**: Emitterschicht
- **600**: Feldpassivierungsschicht
- **700**: Absorberschicht
- **770**: Superstrat
- **800**: Kontaktstreifen
- **900**: Solarzellenbereich
- **990**: Isolationsschicht

- **00**: serienverschaltetes Dünnschicht-Solarmodul
- **01**: Solarzellenbereich
- **02**: Trägerschicht
- **03**: Superstrat
- **04**: Dünnschichtpaket
- **05**: Lichteinfall
- **06**: Absorberschicht
- **07**: Emitterschicht
- **08**: Oberflächenpassivierungsschicht (Funktionsschicht)
- **09**: Solarzellenbereich (benachbart)

- **10**: Solarzellenbereich (benachbart)
- **11**: Feldpassivierungsschicht (Funktionsschicht))
- **12**: erstes Kontaktsystem
- **13**: zweites Kontaktsystem
- **14**: Kontaktierungen (12)
- **15**: äußere Kontaktschicht (12)
- **16**: innere Kontaktschicht (13)
- **17**: Isolationsschicht

- **20**: Serienverschaltung
- **21**: Verschaltungsbereich
- **22**: Serienkontakt
- **23**: Kontaktbereich
- **24**: Totbereich
- **25**: Isoliergraben
- **26**: Trenngraben
- **27**: Kontaktschichtabschnitte

- **30**: Dünnschicht-Solarmodul
- **31**: erstes Kontaktsystem
- **32**: Kontaktierungen (31)
- **33**: Durchkontaktierung (32)
- **34**: Leitschicht
- **35**: Feldpassivierungsschicht (Funktionsschicht)
- **36**: Dünnschicht-Solarmodul
- **37**: erstes Kontaktsystem
- **38**: Kontaktierungen (37)
- **39**: Durchkontaktierung (38)

- **40**: Feldpassivierungsschicht (Funktionsschicht)
- **41**: Oberflächenpassivierungsschicht (Funktionsschicht)

- **50**: Dünnschicht-Solarmodul
- **51**: Emitterschicht
- **52**: Feldpassivierungsschicht (Funktionsschicht)
- **53**: erstes Kontaktsystem
- **54**: Kontaktierungen (53)
- **55**: Durchkontaktierung (54)
- **56**: Oberflächenpassivierungsschicht (Funktionsschicht)
- **57**: weiterer Totbereich

- **60**: Dünnschicht-Solarmodul
- **61**: Emitterschicht
- **62**: erstes Kontaktsystem
- **63**: Kontaktierungen (62)
- **64**: Durchkontaktierung (63)
- **65**: Leitschicht (Funktionsschicht)

- **70**: intrinsische oder schwach dotierte Absorberschicht
- **71**: Dotierschicht (p- oder n-typ, gegensätzlich zu 72)
- **72**: Dotierschicht (n- oder p-typ, gegensätzlich zu 71)
- **75**: Strukturierung
- **76**: Isolationsauskleidung
- **77**: Kontaktierungsöffnung

- **84**: linienförmiger Serienkontakt (22)
- **85**: linienförmiger Isoliergraben (25)
- **86**: punktförmiger Serienkontakt (22)
- **87**: mäanderförmiger Isoliergraben (25)
- **88**: punktförmige Kontaktierung (14)

## Patentansprüche

1. Einseitig kontaktiertes Dünnschicht-Solarmodul mit einer Trägerschicht, einer photoaktiven Absorberschicht und zumindest einer auf einer Seite der Absorberschicht ganzflächig abgeschiedenen Dotierschicht sowie weiteren Funktionsschichten, wobei das daraus gebildete Dünnschichtpaket durch isolierende Trenngräben in Solarzellenbereiche unterteilt ist, und mit einem Kontaktierungen und eine diese verbindende Kontaktschicht aufweisenden ersten Kontaktsystem und einem eine Kontaktschicht aufweisenden zweiten Kontaktsystem auf der trägerschichtabgewandten Seite der Absorberschicht zur getrennten Ableitung von durch Lichteinfall in der Absorberschicht erzeugten überschüssigen Ladungsträgern (p, n), wobei beide Kontaktsysteme innerhalb von Verschaltungsbereichen in Serie geschaltet und außerhalb der Verschaltungsbereiche elektrisch gegeneinander isoliert sind,
**DADURCH GEKENNZEICHNET, DASS**
das zweite Kontaktsystem (13) ausschließlich aus einer inneren Kontaktschicht (16) besteht, die die gesamte trägerschichtabgewandte Seite der Dünnschicht-Solarzellenbereiche (01) flächig zusammenhängend überdeckt und Strukturierungen für die Kontaktierungen (14) des ersten Kontaktsystems (12) aufweist und dass die Kontaktschicht des ersten Kontaktsystems (12) als äußere Kontaktschicht (15) ausgebildet ist, die die Kontaktierungen (14) erfasst, die durch die Strukturierungen (75) in der inneren Kontaktschicht (16) elektrisch isoliert hindurchgreifen, wobei die innere Kontaktschicht (16) und die äußere Kontaktschicht (15) übereinander liegend angeordnet sind und außerhalb der Verschaltungsbereiche (21) mittels Zwischenlage einer Isolationsschicht (17) elektrisch gegeneinander isoliert und innerhalb der Verschaltungsbereiche (21) mittels Serienkontakte (22) miteinander elektrisch leitend verbunden sind.

2. Einseitig kontaktiertes Dünnschicht-Solarmodul nach Anspruch 1,
**DADURCH GEKENNZEICHNET, DASS**
die Serienkontakte (22) linienförmig (84) ausgebildet sind und die äußere Kontaktschicht (15) des ersten Kontaktsystems (12) in den Verschaltungsbereichen (21) durch einen linienförmigen Isoliergraben (85) strukturiert ist oder
die Serienkontakte (22) punktförmig (85) ausgebildet sind und die äußere Kontaktschicht (15) des ersten Kontaktsystems (12) in den Verschaltungsbereichen (21) durch einen meanderförmigen Isoliergraben (87) strukturiert ist.

3. Einseitig kontaktiertes Dünnschicht-Solarmodul nach Anspruch 1,
**DADURCH GEKENNZEICHNET, DASS**
die Kontaktierungen (14) des ersten Kontaktsystems (12) und die Strukturierungen (75) der inneren Kontaktschicht (16) des zweiten Kontaktsystems (13) punkt- oder linienförmig ausgebildet sind.

4. Einseitig kontaktiertes Dünnschicht-Solarmodul nach Anspruch 1,
**DADURCH GEKENNZEICHNET, DASS**
die Trägerschicht (02) als Superstrat (03) ausgebildet ist und die beiden Kontaktsysteme (12,13) auf der dem Lichteinfall (05) abgewandten Seite des Dünnschicht-Solarmoduls (00) angeordnet sind (Rückseitenkontaktierung) oder
die Trägerschicht (02) als Substrat ausgebildet ist und die beiden Kontaktsysteme (12, 13) auf der dem Lichteinfall (05) zugewandten Seite des Dünnschicht-Solarmoduls (00) angeordnet sind (Vorderseitenkontaktierung).

5. Einseitig kontaktiertes Dünnschicht-Solarmodul nach Anspruch 1,
**DADURCH GEKENNZEICHNET, DASS**
eine pn-Konfiguration mit einer dotierten Absorberschicht (06) und zumindest einer gegendotierten Emitterschicht (07) als Dotierschicht zur Trennung der durch Lichteinfall (05) in der Absorberschicht (06) erzeugten überschüssigen Ladungsträger vorgesehen ist.

6. Einseitig kontaktiertes Dünnschicht-Solarmodul nach Anspruch 5,
**DADURCH GEKENNZEICHNET, DASS**
die Absorberschicht (06) oder eine zugehörige ladungsträgerführende Funktionsschicht (11, 34, 40) über die die darüber liegenden Schichten isoliert durchdringenden Kontaktierungen (14) des ersten Kontaktsystems (12) und die Emitterschicht (07, 51, 72) oder eine zugehörige ladungsträgerführende Funktionsschicht (65) mit der inneren Kontaktschicht (16) des zweiten Kontaktsystems (13) kontaktiert sind oder umgekehrt.

7. Einseitig kontaktiertes Dünnschicht-Solarmodul nach Anspruch 5,
**DADURCH GEKENNZEICHNET, DASS**
die Emitterschicht (07, 51, 61, 72) entweder auf der dem Lichteinfall (05) zu- oder abgewandten Seite des Dünnschicht-Solarmoduls (00) angeordnet ist.

8. Einseitig kontaktiertes Dünnschicht-Solarmodul nach Anspruch 1,
**DADURCH GEKENNZEICHNET, DASS**
eine pin-Konfiguration mit einer intrinsischen oder schwach dotierten Absorberschicht (70) und zumindest zwei Dotierschichten (71, 72) gegensätzlicher Dotierung beiderseits der Absorberschicht (70) zur Trennung der durch Lichteinfall (05) in der Absorberschicht (70) erzeugten überschüssigen Ladungsträger vorgesehen ist.

9. Einseitig kontaktiertes Dünnschicht-Solarmodul nach Anspruch 8,
**DADURCH GEKENNZEICHNET, DASS**
eine der beiden Dotierschichten (72) oder eine zugehörige ladungsträgerführende Funktionsschicht (65) über die die darüber liegenden Schichten isoliert durchdringenden Kontaktierungen (14) des ersten Kontaktsystems (12) und die andere Dotierschicht (71) oder eine zugehörige ladungsträgerführende Funktionsschicht mit der inneren Kontaktschicht (16) des zweiten Kontaktsystems (13) kontaktiert ist.

10. Einseitig kontaktiertes Dünnschicht-Solarmodul nach Anspruch 1,
**DADURCH GEKENNZEICHNET, DASS**
als weitere Funktionsschicht eine Antireflexschicht, Saatschicht, Oberflächenpassivierungsschicht (08, 41, 56), Feldpassivierungsschicht (11, 35, 40, 52), Leitschicht (34) und/oder Pufferschicht vorgesehen ist.

11. Einseitig kontaktiertes Dünnschicht-Solarmodul nach Anspruch 1,
**DADURCH GEKENNZEICHNET, DASS**
die zumindest eine Dotierschicht (07, 71, 72) aus zum Halbleitermaterial der Absorberschicht (06, 70) gleichem (Homoausführung) oder unterschiedlichem (Heteroausführung) Halbleitermaterial besteht.

12. Einseitig kontaktiertes Dünnschicht-Solarmodul nach Anspruch 1,
**DADURCH GEKENNZEICHNET, DASS**
die Absorberschicht (06, 70) aus kristallinem Silizium (c-Si) oder aus polykristallinem Silizium (poly-Si), die Emitterschicht (07, 51, 61) oder Dotierschichten (71,72) aus wasserstoffangereichertem amorphem Silizium (a-Si:H) oder aus polykristallinem Silizium (poly-Si), Feldpassivierungsschichten (35, 40, 52) aus wasserstoffangereichertem amorphem Silizium (a-Si:H), Pufferschichten aus intrinsischem amorphem Silizium (i-a-Si), die Isolationsschicht (17) aus Harz oder Silziumoxid, die Leitschicht (65) aus transparentem, leitfähigem Oxid (TCO) oder Molybdän, Oberflächenpassivierungs-, Reflexions- und Antireflexschicht (08, 41, 56) aus Siliziumnitrid (SiN), das Superstrat (03) oder Substrat aus Glas und die Kontaktsysteme (12, 13) aus Aluminium oder aus transparentem, leitfähigem Oxid (TCO) bestehen.

13. Verfahren zur Herstellung eines einseitig kontaktierten Dünnschicht-Solarmoduls nach einem der Ansprüche 1 bis 12,
**DADURCH GEKENNZEICHNET, DASS**
das erste Kontaktsystem (12) mit seinen Kontaktierungen (14) und seiner äußeren Kontaktschicht (15) hergestellt wird durch
• Erzeugen von Strukturierungen (75) im Dünnschichtpaket (04) bis zu der zu kontaktierenden Dotier- oder Funktionsschicht (07, 35, 51, 52, 61, 70, 71) mittels Bohren, Ätzen oder Laserablation,
• elektrisches Isolieren der Strukturierungen (75) durch Einfließenlassen von flüssigem Isoliermaterial und
• ganzflächige, unstrukturierte Metallisierung der Oberfläche des Dünnschichtpakets (04) und der Strukturierungen (75).

14. Verfahren nach Anspruch 13,
**DADURCH GEKENNZEICHNET, DASS**
vor der Metallisierung eine ganzflächige, unstrukturierte Abscheidung einer weiteren Funktionsschicht (11) durchgeführt wird.

15. Verfahren zur Herstellung eines einseitig kontaktierten Dünnschicht-Solarmoduls nach einem der Ansprüche 1 bis 12,
**DADURCH GEKENNZEICHNET, DASS**
die Kontaktierungen (14) des ersten Kontaktsystems (12) und/oder die elektrischen Serienkontakte (22) für die Serienverschaltung der Solarzellenbereiche (01) durch Laserfeuern erzeugt werden.

## Claims

1. A thin-film solar module, contacted on one side, having a backing layer, a photoactive absorber layer and at least one doping layer deposited on one side of the absorber layer over the entire surface as well as additional function layers, wherein the thin-film package formed thereby is subdivided into solar cell regions by insulating trenches, and having a first contact system with contacts and a contact layer connecting these contacts and having a second contact system on the side of the absorber layer facing away from the backing layer, this contact system having a contact layer, for separate derivation of excess charge carriers (p, n) generated by incident light in the absorber layer, wherein the two contact systems are connected in series within wiring regions and are electrically insulated from one another outside of the wiring regions,
**characterized in that**
the second contact system (13) consists exclusively of an inner contact layer (16) which covers the entire side of the thin-film solar cell regions (01) facing away from the backing layer, such that they are cohesive over the entire area, and has structures for the contacts (14) of the first contact system (12); and the contact layer of the first contact system (12) is designed as an outer contact layer (15) which includes the contacts (14) that pass with electrical insulation through the structures (75) in the inner contact layer (16), wherein the inner contact layer (16) and the outer contact layer (15) are arranged one above the other and are electrically insulated from one another outside of the wiring regions (21) by means of an insulation layer (17) inserted in between them and are connected to one another so they are electrically conducting within the wiring regions (21) by means of serial contacts (22).

2. The thin-film solar module, contacted on one side, according to Claim 1,
**characterized in that**
the serial contacts (22) are designed in the form of lines (84) and the outer contact layer (15) of the first contact system (12) is structured by a linear insulation trench (85) in the wiring regions (21) or
the serial contacts (22) are designed as points (85) and the outer contact layer (15) of the first contact system (12) is structured by a meandering insulating trench (87) in the wiring regions (21).

3. The thin-film solar module, contacted on one side, according to Claim 1,
**characterized in that**
the contacts (14) of the first contact system (12) and the structures (75) of the inner contact layer (16) of the second contact system (13) are designed as points or as lines.

4. The thin-film solar module, contacted on one side, according to Claim 1,
**characterized in that**
the backing layer (02) is designed as a superstrate (03) and the two contact systems (12, 13) are arranged on the side of the thin-film solar module (00) facing away from the incident light (05) (rear side contacting) or
the backing layer (02) is designed as a substrate and the two contact systems (12, 13) are arranged on the side of the thin-film solar module (00) facing the incident light (05) (front side contacting).

5. The thin-film solar module, contacted on one side, according to Claim 1,
**characterized in that**
a pn configuration with a doped absorber layer (06) and at least one counter-doped emitter layer (07) as the doping layer is provided for separating the excess charge carriers generated by incident light (05) in the absorber layer (06).

6. The thin-film solar module, contacted on one side, according to Claim 5,
**characterized in that**
the absorber layer (06) or a respective charge carrier-conducting function layer (11, 34, 40) is contacted via the contacts (14) of the first contact system (12), these contacts penetrating through the above layers with insulation, and the emitter layer (07, 51, 72) or a respective charge carrier-conducting function layer (65) is contacted with the inner contact layer (16) of the second contact system (13) or vice versa.

7. The thin-film solar module, contacted on one side, according to Claim 5,
**characterized in that**
the emitter layer (07, 51, 61, 72) is arranged either on the side of the thin-film solar module (00) facing the incident light (05) or on the side facing away from the incident light.

8. The thin-film solar module, contacted on one side, according to Claim 1,
**characterized in that**
a pin configuration with an intrinsic or weakly doped absorber layer (70) and at least two doping layers (71, 72) of opposite doping is provided on both sides of the absorber layer (70) to separate the excess charge carriers created by incident light (05) in the absorber layer (70).

9. The thin-film solar module, contacted on one side, according to Claim 8,
**characterized in that**
one of the two doping layers (72) or a respective charge carrier-conducting function (65) is contacted via the contacts (14) of the first contact system (12) penetrating through the above layers with insulation, and the other doping layer (71) or a respective charge carrier-conducting function layer is contacted with the inner contact layer (16) of the second contact system (13).

10. The thin-film solar module, contacted on one side, according to Claim 1,
**characterized in that**
an anti-reflection layer, a seed layer, a surface passivation layer (08, 41, 56), a field passivation layer (11, 35, 40, 52), a conductive layer (34) and/or a buffer layer is/are provided as an additional function layer.

11. The thin-film solar module, contacted on one side, according to Claim 1,
**characterized in that**
the at least one doping layer (07, 71, 72) is made of semiconductor material of the same semiconductor material (homo embodiment) as the absorber layer (06, 70) or of a different semiconductor material (hetero embodiment).

12. The thin-film solar module, contacted on one side, according to Claim 1,
**characterized in that**
the absorber layer (06, 70) consists of crystalline silicon (c-Si) or of polycrystalline silicon (poly-Si); the emitter layer (07, 51, 61) or doping layers (71, 72) consist of hydrogen-enriched amorphous silicon (a-Si-H) or of polycrystalline silicon (poly-Si); field passivation layers (35, 40, 52) consist of hydrogen-enriched amorphous silicon (a-Si:H); buffer layers consist of intrinsic amorphous silicon (i-a-Si); the insulation layer (17) consists of resin or silicon oxide; the conductive layer (65) consists of transparent conductive oxide (TCO) or molybdenum; the surface passivation layer, reflection layer and anti-reflection layer (08, 41, 56) consist of silicon nitride (SiN); the superstrate (03) or substrate consists of glass; and the contact systems (12, 13) consist of aluminum or transparent conductive oxide (TCO).

13. A method for producing a thin-film solar module, contacted on one side, according to any one of Claims 1 to 12,
**characterized in that**
the first contact system (12) with its contacts (14) and its outer contact layer (15) is produced by
• creating structures (75) in the thin-film package (04) up to the doping or function layer (07, 35, 51, 52, 61, 70, 71) to be contacted by means of drilling, etching or laser ablation,
• electrical insulation of the structures (75) by allowing molten insulation material to flow in and
• whole-area unstructured metallization of the surface of the thin-film package (04) and the structures (75).

14. The method according to Claim 13,
**characterized in that**
a whole-area unstructured deposition of an additional function layer (11) is performed before metallization.

15. The method for producing a thin-film solar module, contacted on one side according to any one of Claims 1 to 12,
**characterized in that**
the contacts (14) of the first contact system (12) and/or the electrical serial contacts (22) for the serial wiring of the solar cell regions (01) are produced by laser firing.

## Revendications

1. Module solaire à couches minces contacté sur une face, avec une couche support, une couche absorbante photoactive et au moins une couche de dopage déposée sur toute la surface sur une face de la couche absorbante, ainsi que des couches fonctionnelles supplémentaires, le paquet de couches minces formé à partir de ces dernières étant divisé par des tranchées de séparation en zones de cellule solaire et avec un premier système de contact comportant des points de contact et une couche de contact reliant ces derniers et un deuxième système de contact comportant une couche de contact sur la face opposée à la couche support de la couche absorbante, pour la dérivation séparée de porteurs de charges (p, n) excédentaires créés par incidence de lumière dans la couche absorbante, les deux systèmes de contact étant montés en série à l'intérieur de zones de circuit et étant électriquement isolés les uns par rapport aux autres à l'extérieur des zones de circuit,
**caractérisé en ce que**
le deuxième système de contact (13) est constitué exclusivement d'une couche de contact interne (16) qui recouvre de façon cohérente en nappe toute la face opposée à la couche porteuse des zones de cellule solaire à couches minces (01) et qui comporte des structurations pour des points de contact (14) du premier système de contact (12) et **en ce que** la couche de contact du premier système de contact (12) est réalisée en tant que surface de contact externe (15), qui comprend les points de contact (14) qui traversent de façon électriquement isolée les structurations (75) dans la couche de contact interne (16), la couche de contact interne (16) et la couche de contact externe (15) étant placées en étant superposées et à l'extérieur des zones de connexion (21) étant mutuellement isolées électriquement les unes par rapport aux autres par des couches intermédiaires d'une couche isolante (17) et à l'intérieur des zones de connexion (21) étant mutuellement reliées de façon conductrice d'électricité, au moyen de contacts sériels (22).

2. Module solaire à couches minces contacté sur une face selon la revendication 1,
**caractérisé en ce que**
les contacts sériels (22) sont réalisés en forme de lignes (84) et la couche de contact externe (15) du premier système de contact (12) est structurée dans les zones de connexion (21) par une tranchée isolante (85) de forme linéaire ou
les contacts sériels (22) sont réalisés en forme de points (85) et la couche de contact externe (15) du premier système de contact (12) est structurée dans les zones de connexion (21) par une tranchée isolante (87) en forme de méandres.

3. Module solaire à couches minces contacté sur une face selon la revendication 1,
**caractérisé en ce que**
les points de contact (14) du premier système de contact (12) et les structurations (75) de la couche de contact interne (16) du deuxième système de contact (13) sont réalisés sous forme de points ou de lignes.

4. Module solaire à couches minces contacté sur une face selon la revendication 1,
**caractérisé en ce que**
la couche support (02) est réalisée sous la forme d'un superstrat (03) et **en ce que** les deux systèmes de contact (12, 13) sont placés sur la face du module solaire à couches minces (00) qui est opposée à l'incidence de lumière (05) (contact sur la face arrière) ou
la couche support (02) est réalisée sous la forme d'un substrat et les deux systèmes de contact (12, 13) sont placés sur la face du module solaire à couches minces (00) qui est dirigée vers l'incidence de lumière (05) (contact sur la face avant).

5. Module solaire à couches minces contacté sur une face selon la revendication 1,
**caractérisé en ce qu'**
une configuration pn avec une couche absorbante (06) dopée et au moins une couche émettrice (07) contre-dopée sont prévues en tant que couche de dopage pour la séparation des porteurs de charges excédentaires créés par incidence de lumière (05) dans la couche absorbante (06).

6. Module solaire à couches minces contacté sur une face selon la revendication 5,
**caractérisé en ce que**
la couche absorbante (06) ou une couche fonctionnelle (11, 34, 40) associée, conductrice de porteurs de charge est mise en contact par l'intermédiaire des points de contacts (14) du premier système de contact (12) traversant de façon isolée les couches sus-jacentes et la couche émettrice (07, 51, 72) ou une couche fonctionnelle (65) associée, conductrice de porteurs de charge est mise en contact avec la couche de contact interne (16) du deuxième système de contact (13) ou inversement.

7. Module solaire à couches minces contacté sur une face selon la revendication 5,
**caractérisé en ce que**
la couche émettrice (07, 51, 61, 72) est placée soit sur la face dirigée vers ou opposée à l'incidence lumineuse (05) du module solaire à couches minces (00).

8. Module solaire à couches minces contacté sur une face selon la revendication 1,
**caractérisé en ce qu'**
une configuration pin est prévue avec une couche absorbante (70) intrinsèque ou faiblement dopée et au moins deux couches de dopage (71, 72) de dopage opposé de part et d'autre de la couche absorbante (70) pour la séparation des porteurs de charges excédentaires créés par incidence de lumière (05) dans la couche absorbante (70).

9. Module solaire à couches minces contacté sur une face selon la revendication 8,
**caractérisé en ce que**
l'une des deux couches de dopage (72) ou une couche fonctionnelle (65) associée, conductrice de porteurs de charge est mise en contact par l'intermédiaire des points de contact (14) du premier système de contact (12) traversant de façon isolée les couches sus-jacentes et l'autre couche de dopage (71) ou une couche fonctionnelle associée, conductrice de porteurs de charge est mise en contact avec la couche de contact interne (16) du deuxième système de contact (13).

10. Module solaire à couches minces contacté sur une face selon la revendication 1,
**caractérisé en ce qu'**
en tant que couche fonctionnelle supplémentaire, il est prévu une couche antiréfléchissante, une couche de germe, une couche de passivation superficielle (08, 41, 56), une couche de passivation de champ (11, 35, 40, 52), une couche conductrice (34) et/ou une couche tampon.

11. Module solaire à couches minces contacté sur une face selon la revendication 1,
**caractérisé en ce que**
l'au moins une couche de dopage (07, 71, 72) est constituée d'un matériau semi-conducteur identique (version homo) ou différente (version hétéro) du matériau semi-conducteur de la couche absorbante (06, 70).

12. Module solaire à couches minces contacté sur une face selon la revendication 1,
**caractérisé en ce que**
la couche absorbante (06, 70) est constituée d'un silicium cristallin (c-Si) ou d'un silicium poly-cristallin (poly-Si), la couche émettrice (07, 51, 61) ou les couches de dopages (71, 72) sont constituées de silicium amorphe hydrogéné (a-Si:H) ou de silicium poly-cristallin (poly-Si), les couches de passivation de champ (35, 40, 52) sont constituées de silicium amorphe hydrogéné (a-Si:H), les couches tampons sont constituées de silicium amorphe intrinsèque (i-a-Si), la couche isolante (17) est constituée de résine ou d'oxyde de silicium, la couche conductrice (65) est constituée d'oxyde conducteur transparent (TCO) ou de molybdène, la couche de passivation superficielle, de réflexion ou antiréfléchissante (08, 41, 56) est constituée de nitrure de silicium (SiN), le superstrat (03) ou le substrat est constitué de verre et les systèmes de contact (12, 13) sont constitués d'aluminium ou d'oxyde conducteur transparent (TCO).

13. Procédé de fabrication d'un module solaire à couches minces contacté sur une face selon l'une quelconque des revendications 1 à 12,
**caractérisé en ce qu'**
on fabrique le premier système de contact (12) avec ses points de contact (14) et sa couche de contact extérieure (15) par
• création de structurations (75) dans le paquet de couches minces (04) jusqu'à la couche de dopage ou fonctionnelle (07, 35, 51, 52, 61, 70, 71) qui doit être mise en contact par perçage, mordançage ou ablation laser,
• isolation électrique des structurations (75) en laissant couler du matériau isolant liquide et
• métallisation non structurée à pleine surface de la surface du paquet de couches minces (4) et des structurations (75).

14. Procédé selon la revendication 13,
**caractérisé en ce qu'**
avant la métallisation, on procède à un dépôt non structuré d'une couche fonctionnelle (11) supplémentaire.

15. Procédé de fabrication d'un module solaire à couches minces contacté sur une face selon l'une quelconque des revendications 1 à 12,
**caractérisé en ce que**
les points de contact (14) du premier système de contact (12) et/ou les contacts électriques sériels (22) sont créés pour la connexion en série des zones de cellule solaire (01) par étincelage laser.
